Europäisches Patentamt

European Patent Office

Office européen des brevets

(11) Publication number: **0 407 111 A2**

## EUROPEAN PATENT APPLICATION

(21) Application number: **90307177.7**

(22) Date of filing: **29.06.90**

(51) Int. Cl.⁵: **H01L 29/08, H01L 21/331**

(30) Priority: **01.07.89 GB 8915171**

(43) Date of publication of application:
**09.01.91 Bulletin 91/02**

(84) Designated Contracting States:
**DE FR IT NL**

(71) Applicant: **THE GENERAL ELECTRIC COMPANY, p.l.c.**
**1 Stanhope Gate**
**London W1A 1EH(GB)**

(72) Inventor: **Lau, Dominic Wai-Fung**
**127 Andover Avenue, Alkrington**
**Middleton, Manchester M24 1JQ(GB)**

(74) Representative: **Lawrence, Brian Richard et al**
**GEC Patent Department GEC-Marconi**
**Research Centre West Hanningfield Road**
**Great Baddow**
**Chelmsford, Essex CM2 8HN(GB)**

(54) **A method for fabrication of a collector-diffused isolation semiconductor device.**

(57) A method in which an N well 27 is formed in a collector diffused isolation device by transformation of an epitaxial layer 23 of P type material to N type or vice-versa. This reduces the base area 32 and so allows an increase in cut-off frequency $F_T$.

Fig.9

EP 0 407 111 A2

# A METHOD FOR FABRICATION OF A COLLECTOR-DIFFUSED ISOLATION SEMICONDUCTOR DEVICE

The present invention relates to a method for fabrication of a collector-diffused semiconductor device.

A collector-diffused isolation (CDI) transistor has a low mask count i.e. there is no need for a multitude of mask layers in order to manufacture an active device.

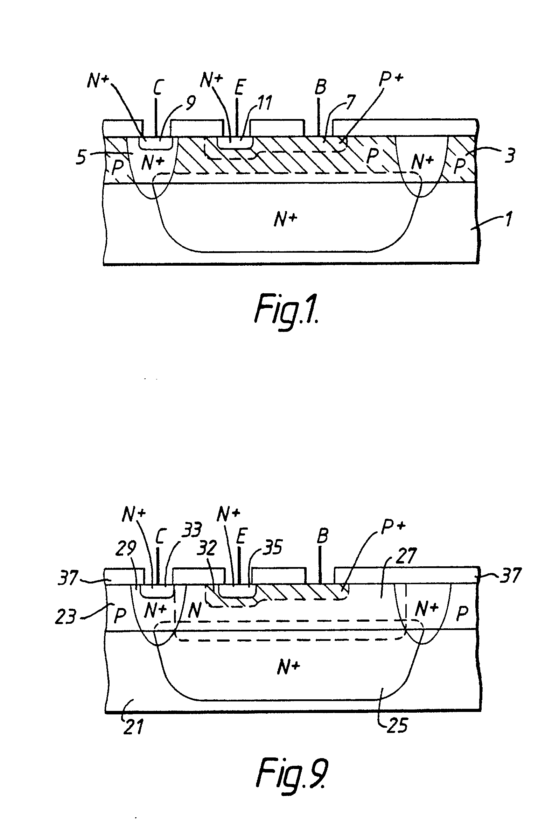

A known collector-diffused isolation device or transistor is illustrated in Figure 1. An epitaxial layer 3 of p-type material is deposited upon a substrate. A collector area 5 is diffused or implanted through the epitaxial layer 3 and a base area 7 of the layer 3 is doped or implanted to become P+ type material. Within the collector area 5 and base area 7, a collector contact 9 and an emitter contact 11 are provided by doping. The collector contact 9 and emitter contact 11 are both of N+ type material.

The width of the base area 7 is controlled by the epitaxial layer 3 and the base diffusion, consequently it is difficult to fabricate the base area 7 with a narrow width. This leads to a problem with CDI transistors namely that of a low cut-off frequency ($F_T$) due to the shunt effect of a relatively large capacitance. (See Physics of Semiconductor Devices S.M. Sze p 158-9 (2nd Edition, Wiley)).

It is an objective of the present invention to provide a collector-diffused isolation (CDI) transistor having a relatively reduced base area width.

According to a first embodiment of the present invention there is provided a method for fabricating a collector diffused isolation device comprising a P type epitaxial layer upon a substrate with a diffused N+ type collector and a diffused N+ type emitter in a diffused P+ type base volume, the method being characterised in that at least a portion of the P type epitaxial layer is counter-doped to N type for the entire epitaxial depth to facilitate a more accurate definition of the base volume and to allow fabrication of a collector diffused isolation device having a reduced base volume width compared to conventional collector diffused isolation devices whilst selective counter doping preserves collector diffused isolation.

According to a second embodiment of the present invention there is provided a method for fabricating a collector diffused isolation device comprising an N type epitaxial layer upon a substrate with a diffused P+ type collector and a diffused P+ type emitter in a diffused N+ type base volume, the method being characterised in that at least a portion of the N type epitaxial layer is counter-doped to P type for the entire epitaxial depth to facilitate a more accurate definition of the base volume and to allow fabrication of a collector diffused isolation device having a reduced base volume width compared to conventional collector diffused isolation devices whilst selective counter doping preserves collector diffused isolation.

An embodiment of the present invention will now be described by way of example only with reference to the accompanying drawings, in which:-

Figures 2 to 8 illustrate schematically, steps in the method of fabrication of a collector diffused device according to the present invention; and,

Figure 9 illustrates, schematically, a collector diffused device according to the present invention.

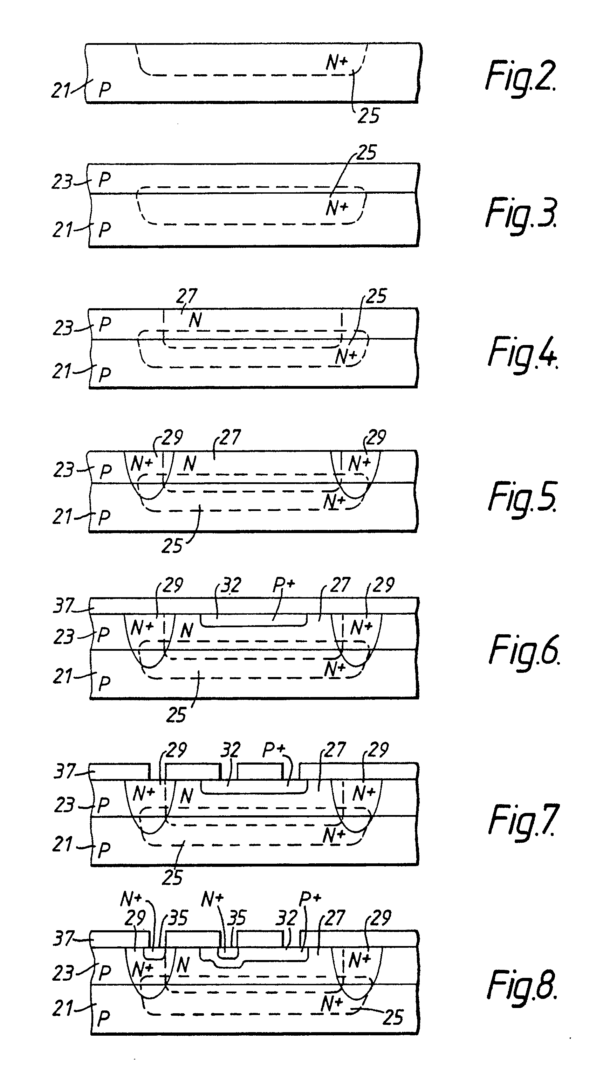

Referring to Figure 2, upon a P type substrate 21, an N+ type material slab 25 is formed, for example by gaseous diffusion or ion implantation.

As illustrated in Figure 3, an epitaxial layer 23 of P type material is deposited on the P type substrate 21.

In accordance with the invention as illustrated in Figure 4, an N type material well 27 is formed through the epitaxial layer 23 and extends into the slab 25 using standard VLSI masking techniques. This well 27 may be formed by gaseous diffusion or ion implantation.

In Figure 5, a collector volume 29 is doped to form an N+ type material enclosing the N type material well 27.

A base area 32 of narrow width is deposited by diffusion or ion implantation, as illustrated in Figure 6. An oxide layer 37 is then formed on the surface of layer 23 by thermal oxidation.

In Figure 7, apertures are opened in the oxide layer 37 to allow subsequent contact to collector area 29, and base area 32.

Finally, a collector contact 33 and an emitter 35 each of N+ type material are then formed respectively in the collector volume 29 and base area 32 (Figure 8).

It will be appreciated that in accordance with the present invention it is the formation of an N-type material well 27 through the P-type epitaxial layer 23 that allows a base area 32 of narrow width to be formed. The effect of counter-doping of the epitaxial layer 23 is to form the N type material well 27.

In the present method the N-type material well can be defined by a simple photolithographic technique thus retaining the simplicity of the collector diffused isolation (CDI) approach.

An N-well CDI transistor is schematically illustrated in Figure 9. If a comparison is made to Figure 1, it will be seen that the collector (C)/base (B) junction area is significantly reduced by the introduction of an N-well 27. Futhermore, the N-well CDI transistor has a lower collector-base capacitance, higher sustaining voltage, a good early voltage and a better collector/base voltage.

It will be appreciated that although the invention has been illustrated with respect to an NPN transistor, the invention could be equally applied to PNP transistors, resistors diodes and capacitors.

## Claims

1. A method for fabricating a collector diffused isolation device comprising a P type epitaxial layer upon a P type substrate with a diffused N+ type collector and a diffused N+ type emitter in a diffused P+ type base volume, the method being characterised in that at least a portion of the P type epitaxial layer is counter-doped to N type for the entire epitaxial depth to facilitate a more accurate definition of the base volume and to allow a fabrication of a collector diffused isolation device having a reduced base volume width compared to conventional collector diffused isolation devices whilst selective counter doping preserves collector diffused isolation.

2. A method for fabricating a collector diffused isolation device comprising an N type epitaxial layer upon a N type substrate with a diffused P+ type collector and a diffused P+ type emitter in a diffused N+ type base volume, the method being characterised in that at least a portion of the N type epitaxial layer is counter-doped to P type for the entire epitaxial depth to facilitate a more accurate definition of the base volume and to allow fabrication of a collector diffused isolation device having a reduced base volume width compared to conventional collector diffused isolation devices whilst selective counter doping preserves collector diffused isolation.

3. A method as claimed in claim 1 or 2 wherein the epitaxial layer is counter-doped by diffusion.

4. A method as claimed in claim 1 or 2 wherein the epitaxial layer is counter-doped by ion implantation.

5. A collector diffused isolation device having a base area formed within a N type or P type material well.

Fig.1.

Fig.9.

Fig.2.

Fig.3.

Fig.4.

Fig.5.

Fig.6.

Fig.7.

Fig.8.